# EUROPEAN PATENT APPLICATION

(11) **EP 4 687 384 A1**
(43) Date of publication of application: **04.02.2026**
(21) Application number: 24306320.3
(22) Date of filing: 02.08.2024
(51) Int. Cl.: H05K 7/20, F28F 13/10, G06F 1/20

(54) **COOLING BLOCK FOR A DATACENTER SERVER RACK**

(71) Applicant: OVH, 59100 Roubaix (FR)
(72) Inventor: CHEHADE, Ali, 59283 Moncheaux (FR); HNAYNO, Mohamad, 59100 Roubaix (FR)
(74) Representative: BCF Global

(57) **Abstract**

The instant disclosure relates to a cooling block (**160**) for cooling a heat-generating electronic component (**166**), comprising:
a body (**162**) having an external surface (**162**), called thermal transfer surface, configured to be placed in thermal contact with the heat-generating electronic component,
the body defining a fluid conduit (115) for circulating a cooling fluid therein, the fluid conduit having at least an inlet (110) for receiving the cooling fluid and at least an outlet (112) for discharging the cooling fluid,
the cooling block further comprising at least one acoustic wave generator (**200**), called vibrations element, configured to generate a field of vibrations of the cooling liquid in the fluid conduit, called vibrations area.

## Description

### FIELD OF TECHNOLOGY

The present technology relates to datacenter server rack cooling.

### BACKGROUND

Datacenters are configured to house multitudes of server racks containing electronic equipment, such as computer systems (e.g., server assemblies), memory banks, etc. in efforts to process vast amounts of data in near real time. During operations, the electronic equipment of the server racks generates a significant amount of heat that must be dissipated in order to ensure continued efficient operation of the electronic equipment. Many cooling solutions have been implemented to address this heating issue, including the liquid cooling of heat-generating components by way of liquid cooling blocks directly mounted onto certain heat-generating components (often referred to as liquid or water block units).

Although water block units are capable of efficiently cooling the heat-generating components, their implementation in server racks typically requires a liquid distribution infrastructure to service the multitude of server racks and the vast number of electronic equipment supported therein. Such liquid distribution infrastructures conventionally require the use of relatively large and/or heavy piping conduit configurations and large capacity pumps to maintain the necessary liquid flow rates that supply the water blocks to service the cooling needs of the vast number of corresponding heat-generating components. It will be appreciated that the use of such piping conduit configurations and large pumps can be prohibitively costly for datacenters, in terms of initial investments and operating costs. Such piping conduit configurations and large pumps inherently occupy large footprints which may reduce a productivity (*e.g.* server per unit area of datacenter floor surface).

As a result, it appears to be desirable to provide a liquid cooling arrangement for datacenter server racks that can alleviate at least some of the cost issues and/or improve the efficiency of the cooling solution.

It is to be noted that the subject matter discussed in the background section should not be assumed to be prior art merely as a result of its mention in the background section. Similarly, the issues mentioned in the background section should not be interpreted as having been recognized in the prior art.

### SUMMARY

According to one aspect of the present technology, there is provided a cooling block for cooling a heat-generating electronic component, comprising:
a body having an external surface, called thermal transfer surface, configured to be placed in thermal contact with the heat-generating electronic component,
the body defining a fluid conduit for circulating a cooling fluid therein, the fluid conduit having at least an inlet for receiving the cooling fluid and at least an outlet for discharging the cooling fluid,
the cooling block further comprising at least one acoustic wave generator, called vibrations element, configured to generate a field of vibrations of the cooling liquid in the fluid conduit, called vibrations area.

Thanks to the vibrations element(s), the flow of the cooling liquid is locally changed, which helps a reduction of the boundary layer and/or increases local turbulences in the liquid flow, and, consequently, enhances the thermal exchanges between the cooling liquid and the air, thus optimizing the efficiency of the cooling block.

In some embodiments, a frequency of the vibrations element is comprised between 30 Hz and 500 Hz, advantageously 150 Hz to 300Hz, and/or 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz.

In some embodiments, the vibrations element is arranged on the external surface of the body.

In some embodiments, the vibrations element is configured such that the field generated presents a principal direction forming an angle between 0° to 360° with a longitudinal axis of the cooling block.

In some embodiments, the cooling block comprises at least a first vibrations element and a second vibrations element.

In some embodiments, the first and second vibrations elements are configured such that a frequency of the first vibrations element is different from a frequency of the second vibrations element.

In some embodiments, the first and second vibrations elements are configured such that that the field generated by the first vibrations element presents a principal direction forming a non-zero angle with a principal direction of the field generated by the second vibrations element.

In some embodiments, the principal direction of the field generated by the first vibrations element is perpendicular to the principal direction of the field generated by the second vibrations element.

In some embodiments, an acoustic power of the acoustic waves generator is comprised between 50 W and 200 W, advantageously 100 W.

The present invention also relates to a liquid cooling arrangement for of a datacenter server rack, comprising:
a liquid cooling loop configured to convey a cooling liquid;
a plurality of server clusters, each server cluster including a plurality of server assemblies that incorporate at least one respective liquid cooling unit as already described and configured to collect at least a portion of a thermal energy generated by a heat-generating component;
at least one heat exchanger fluidly connected to the liquid cooling units of the plurality of server clusters via the liquid cooling loop; and
a pump fluidly coupled to the heat exchanger via the liquid cooling loop, the pump configured to convey the cooling liquid in the liquid cooling loop.

In some embodiments, said at least one exchanger is disposed on a rear door of a rack hosting the server clusters.

In some embodiment, said at least one exchanger is configured to cool the air flow with the cooling liquid circulating in the thermal exchanges zone.

Implementations of the present technology each have at least one of the above-mentioned objects and/or aspects, but may not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 depicts a functional block diagram of a serialized liquid cooling arrangement for a datacenter server rack, in accordance with some non-limiting embodiments of the present disclosure;
FIG. 2 depicts a cooling block of the arrangement of FIG. 1 equipped with a vibrations elements, in accordance with some non-limiting embodiments of the present disclosure.
FIG. 3 depicts a cooling block of the arrangement of FIG. 1 equipped with a several vibrations elements, in accordance with some non-limiting embodiments of the present disclosure.
FIG. 4 depicts a detail of the cooling block of FIG. 2 and 3, in accordance with some non-limiting embodiments of the present disclosure.

### DETAILED DESCRIPTION

The instant disclosure presents various embodiments of vibrations elements that optimize the cooling of heat generating electronic components.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

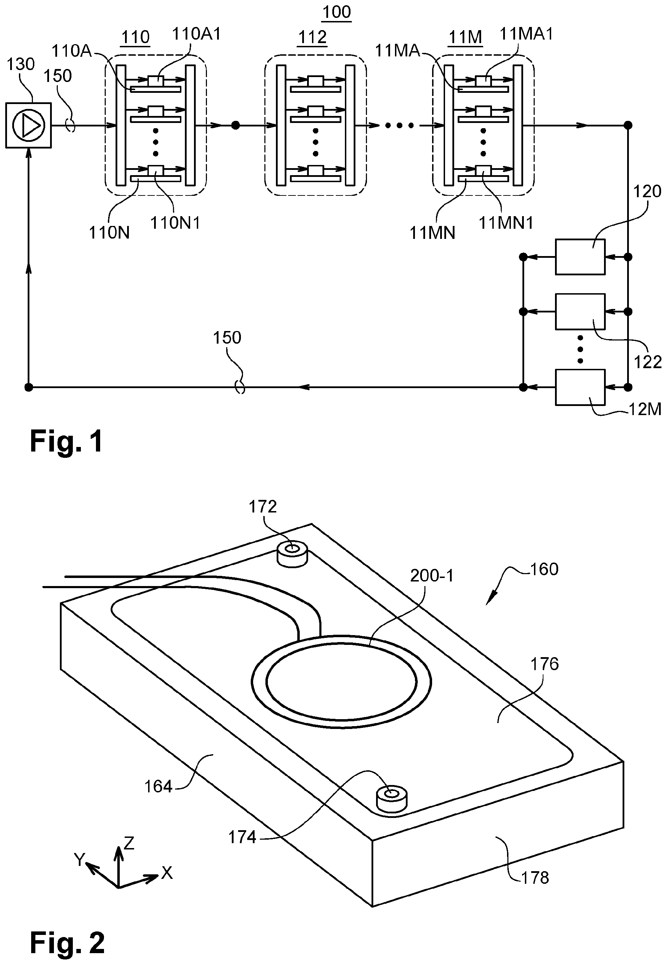

A three-axis coordinate system (X, Y, Z) is illustrated on FIG.2 to FIG. 4 to ensure a better understanding of the following description of the invention. The Y axis is called longitudinal axis.

With these fundamentals in place, we will now consider some non-limiting examples to illustrate the implementations of the various inventive aspects of the present disclosure.

FIG. 1 depicts a functional block diagram of a server rack serialized liquid cooling arrangement **100,** in accordance with the embodiments of the present disclosure. As shown, liquid cooling arrangement **100** includes a plurality of server clusters **110, 112** ... **11M** that are fluidly connected in series to each other via a server rack liquid cooling loop **150.** The server rack liquid cooling loop **150** is configured to convey and facilitate the flow of a cooling liquid throughout the electronic equipment of the server rack and may be constructed from flexible materials (*e.g.,* rubber, plastic, *etc*.), rigid materials (*e.g.,* metal, PVC piping, *etc*.), or any combination of thereof. It will be appreciated that the conveyed liquid may include water, alcohol, or any suitable liquid capable of sustaining adequate cooling temperatures.

Each of the server clusters **110, 112** ... **11M** includes a plurality of server assemblies **110A-110N, 112A-112N** ... **11MA-11MN** that are arranged in a parallel and/or serialized manner. As noted above, the server assemblies **110A-110N, 112A-112N** ... **11MA-11MN** contain heat generating electronic components.

Accordingly, each of the parallel server assemblies **110A-110N, 112A-112N** ... **11MA-11MN** incorporates at least one respective liquid cooling unit or block **110A1-110N1, 112A1-112N1** ... **11MA1-11MN1,** correspondingly arranged in parallel, for the direct thermal contact liquid cooling of the heat generating electronic components. That is, each of the liquid cooling units **110A1-110N1, 112A1-112N1** ... **11MA1-11MN1** is configured as liquid-cooled heat sink conduit block that is thermally coupled, either directly or indirectly, to the heat-generating electronic components, such that cooling liquid is circulated through internal liquid conduits of the liquid cooling units **110A1-110N1, 112A1-112N1** ... **11MA1-11MN1** to absorb the heat from the heat-generating electronic components and discharge the heated liquid therefrom. The liquid cooling units will be described in detail later.

Heat-generating components are for instance graphics processing units (GPU) and/or central processing units (CPU). Other components are for instance random-access memory (RAM), hard drives ...

For example, each one of the server clusters **110, 112** ... **11M** may include a first manifold that, in use, receives the cooling liquid and feeds the cooling liquid to the plurality of liquid cooling units of the server cluster in parallel. A second manifold may be provided downstream said plurality of liquid cooling units to receive the cooling liquid from the plurality of liquid cooling units.

The liquid cooling arrangement **100** further includes at least one air-to-liquid heat exchangers (ALHEXs), three on FIG. 1, 120, 122 ... 12M.

On FIG. 1, each of the air-to-liquid heat exchangers (ALHEXs) **120, 122 ... 12M** defines an exchanger internal fluid conduit that forms a part of the cooling loop **150.** Therefore, each of the air-to-liquid heat exchangers (ALHEXs) **120, 122** ... **12M** has an inlet through which, in use, the cooling liquid flows into the exchanger internal fluid conduit, and an outlet through which, in use, the cooling liquid is discharged from the exchanger internal fluid.

On FIG. 1, the ALHEXs **120, 122** ... **12M** of the liquid cooling arrangement **100** are fluidly connected in parallel with one another. Namely, the internal fluid conduits of the air-to-liquid heat exchangers (ALHEXs) **120, 122** ... **12M** of the liquid cooling arrangement **100** are fluidly connected in parallel. The ALHEXs **120, 122** ... **12M** of the liquid cooling arrangement 100 are also fluidly coupled to server clusters **110, 112** ... **11M** via the liquid cooling loop **150.** The ALHEXs **120, 122** ... **12M** function to sufficiently air cool the heated liquid received by the liquid cooling units **110A1-110N1, 112A1-112N1** ... **11MA1-11MN1** for redirection back to the server clusters **110, 112** ... **11M**. The ALHEXs **120, 122** ... **12M** may embody any suitable configuration that reduces liquid temperatures through supplied air flow, such as, internal cooling coils, heat extracting air flow fins, *etc.* The ALHEXs **120, 122** ... **12M** may be, for example and without limitations, disposed on rear doors of a rack hosting the server clusters **110, 112 ... 11M**.

The liquid cooling arrangement **100** additionally includes at least one pump **130** that is fluidly connected to the server rack liquid cooling loop **150.** The pump **130** is configured to receive the cooling liquid from the ALHEXs **120, 122** ... **12M,** via the server rack liquid cooling loop **150,** and functions to forcibly provide the necessary circulatory flow rate of the cooling liquid through the server rack liquid cooling loop **150,** in order to service the liquid cooling units **110A1-110N1, 112A1-112N1** ... **11MA1-11MN1** of server clusters **110, 112 ... 11M**.

The present disclosure is not limited to the configuration of FIG. 1. For instance, the heat exchangers ALHEX **120, 122** ... **12M** can be dedicated each to a respective server cluster rather than being in parallel one with another, and/or some of the server clusters can be serialized while others can be connected in parallel one with another.

Also, it should be noted that the ALHEX **120, 122** ... **12M** can have other roles in the loop **150.** On FIG. 1, the liquid is cooled in the ALHEX **120, 122 ... 12M** by an air flow. However, the present disclosure also encompasses embodiments wherein the cooling liquid flowing inside the ALHEX **120, 122** ... **12M** can be used to cool an air flow of the rack.

One of the liquid cooling units **110A1-110N1, 112A1-112N1** ... **11MA1-11MN1** is now described in relationship with FIG. 2 to FIG. 4. The cooling unit is also called cooling block or water block assembly, and referred to as WB assembly, **160.**

Advantageously, each cooling unit can incorporate a serpentine to cool the dielectric fluid.

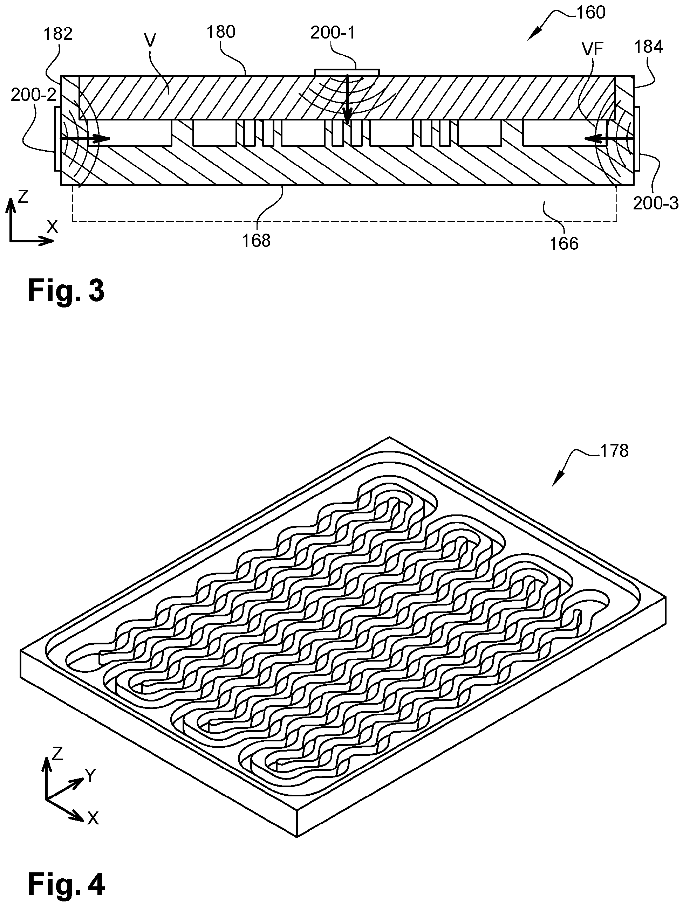

As can be seen from FIG. 2 and FIG. 3, the WB assembly **160** comprises a body **162** having an external surface **164** that defines an internal volume V. A heat-generating component **166** lies against a portion **168** of the external surface **164,** such that heat is transferred from the component **166** to the WB assembly **160** (see FIG. 3).

The water block assembly WB also comprises a cooling liquid conduit **170** in the internal volume V, as well as at least an inlet **172** for ingressing the cooling liquid in the conduit **170** from the liquid cooling loop **150** and an outlet **174** for egressing the cooling liquid out of the conduit 168 to the liquid cooling loop **150.**

On the illustrated embodiment, the WB assembly **160** comprises only one inlet **172** and one outlet **174.** However, the present disclosure is not limited to this specific arrangement, and the WB assembly **160** can be provided with more inlets and/or outlets.

The shape of the cooling liquid conduit **170** depends on several parameters, like the material and size of the WB assembly, for instance. The conduit **170** preferably presents a serpentine shape to enhance thermal exchanges between the heat-generating component **166** and the WB assembly **160.** As can be seen, the body **162** of the WB assembly **160** is made of two-half-shells **176, 178,** the conduit **170** being formed by the two-halves. A non limiting example of the conduit **170** is shown in FIG. 4. The plane (X, Y) is called the main plane of the cooling liquid conduit **170.** The heat-generating element **166** is located on the half **178** on FIG. 3.

The WB assembly **160** is equipped with at least one acoustic wave generator **200,** called vibrations element, for generating a field of mechanical vibrations of the cooling liquid in the WB assembly **160,** as will now be detailed.

The vibrations element **200** is preferably an ultrasonic wave generator, like a piezoelectric transducer.

On FIG. 2, a first vibrations element **200-1** is illustrated while on FIG. 3, two other vibrations elements **200-2** and **200-3** are visible. As can be seen from FIG. 3, the first vibrations element **200-1** lies against a surface **180** (X, Y) opposed to the portion **168** of the external surface **164,** while the second and third vibrations elements **200-2, 200-3** are located on two opposed portions **182, 184** (Y, Z) of the body **162.**

The present disclosure encompasses embodiments wherein the WB assembly **160** is equipped with only one vibrations element **200,** or several vibrations elements **200.** The vibrations elements **200** can be identical or on the contrary of different types, depending on the level of impact to induce to the flowing of the cooling liquid. The number of vibrations elements, their positioning and their size depend on the level of thermal exchanges that are needed between the heat-generating component **166** and the WB assembly **160,** as well as the size of the WB assembly **160.**

Each vibrations element **200** is configured to generate a vibrational field VF at a given frequency f that induces local modifications of the flowing of the cooling liquid, as will be detailed later. Each vibrational field VF presents a principal direction, corresponding to the main direction of the propagation of the vibrations that are generated by the vibrations element **200.** The principal direction is illustrated by an arrow on the figures. The area where the vibrations are created in the cooling liquid flow is called vibrations area.

The vibrations elements **200** can be located either inside the WB assembly or outside of it, but in each case, each vibrations element **200** is located such that the vibrational field VF has an impact on the cooling liquid.

On FIG. 3, the principal direction of the first vibrations element **200-1** extends along the Z-axis while the principal directions of the second and third vibrations elements **200-2, 200-3** extend along the Y-axis. In other word, the principal directions of the second and third vibrations elements **200-2, 200-3** extend in the main plane (X, Y) of the cooling liquid conduit 168 whereas the principal direction of the first vibrations element **200-1** extends perpendicularly to that plane.

The present disclosure is not limited to the configuration of FIG. 2 and FIG. 3. The WB assembly **160** can be equipped with less than three vibrations elements **200,** or on the contrary with more vibrations elements **200.** Also, the WB assembly **160** can be equipped with more than one vibrations elements on the half **176** and/or the more or less vibrations elements on the longitudinal walls **182, 184.** Furthermore, on FIG. 2, the present disclosure also encompasses configurations wherein the principal directions do not all belong to a same plane or on the contrary belong to a same plane.

It should be noted that the frequencies of the vibrations element **200** can be comprised between 10 Hz to 5 Mz, like between 30 Hz and 500 Hz, advantageously 100 Hz to 300Hz, advantageously 150 Hz to 300 Hz, advantageously 50 Hz to 200 Hz, and/or 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz, between 1.7 MHz to 2.5 MHz.

Preferably, the vibrations elements **200** are ultrasonic transducers.

As is known, ultrasound is sound with frequencies from 20 kHz up to several gigahertz. When the frequency of the ultrasonic transducer **200** is comprised between 20 kHz and 50 kHz, advantageously 25 kHz, cavitation is generated, which can reduce the thickness of the boundary layer, hence enhancing thermal exchanges in the WB assembly **160** between the heat-generating components **166** and the cooling liquid. When the frequency of the ultrasonic transducer **200** is comprised between 1.8 MHz and 2.2 MHz, advantageously 2 MHz, an acoustic flow is generated, which increases local turbulences of the heat-transfer liquid flow, hence enhancing thermal exchanges in the WB assembly **160.** When the frequency of the ultrasonic transducer 200 is comprised between 800 kHz and 1.8 MHz, advantageously 800 kHz to 1.2 MHz, advantageously 1 MHz, there is a combination of cavitation and acoustic flow that enhances thermal exchanges in the heat exchanger.

It should be noted that the Reynolds number of the heat-transfer liquid can be comprised between 500 to 10 000, advantageously between 500 and 800, advantageously between 900 and 5000. The ultrasound transducer **200** has less impact on the cooling liquid flow when the Reynolds number is higher, such that the liquid cooling arrangement is preferred with a Reynolds number between 500 and 800.

The ultrasonic power of the ultrasonic transducer **200** is comprised between 50 W and 200 W, advantageously 100 W.

Two ultrasonic transducers can be positioned such that the principal direction of the field of the first transducer **200-1** forms an angle with the principal direction of the field of the second transducer **200-2** that is comprised between 0° and 360°, preferably between 0° and 180°. On FIG. 3, the two ultrasonic transducers can be either colinear (**200-2, 200-3**) or perpendicular (**200-1** with **200-2** or **200-3**) or form another angle, depending on the level of impact on the cooling liquid.

Two ultrasonic transducers can be of the same frequencies and ultrasonic power, or, on the contrary of different frequencies and/or ultrasonic power. For instance, the WB assembly **160** can comprise a first and second ultrasonic transducers of a frequency lower than 1MHz, lower than 500kHz, lower than 100Kz and a third and fourth ultrasonic transducer of a frequency comprised between to 1MHz and 1.5 MHz, or between 1.8 MHz and 2.5 MHz.

As already explained, depending on the number of vibrations elements **200,** on their positioning, their frequencies and acoustic power, and their relative directions of their principal directions, the boundary layer is reduced, turbulences are increased, which results in a better heat transfer in the WB assembly **160.**

In other words, when equipped with the vibrations elements **200,** the WB assembly **160** improves its efficiency because of the optimization of the thermal exchanges between the heat-transfer liquid and the components (because of a reduction of the boundary layer and/or current flow, for instance). Having several vibrations elements improves the thermal exchanges even better thanks to a synergy that can appear when the vibrations elements have different frequencies and/or positionings relative one to another. Another advantage is that the WB assembly **160** can be chosen more compact given the optimized thermal exchanges.

Preferably, the heat exchangers are disposed at the rear door of the on rear doors of a rack hosting the server clusters **110, 112 ... 11M,** as already explained.

The present disclosure is of particular interest wherein the cooling liquid flowing inside the ALHEX **120, 122** ... **12M** can be used to cool an air flow of the rack.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A cooling block **(160)** for cooling a heat-generating electronic component **(166),** comprising:
a body **(162)** having an external surface **(162),** called thermal transfer surface, configured to be placed in thermal contact with the heat-generating electronic component,
the body defining a fluid conduit (115) for circulating a cooling fluid therein, the fluid conduit having at least an inlet (110) for receiving the cooling fluid and at least an outlet (112) for discharging the cooling fluid,
the cooling block further comprising at least one acoustic wave generator **(200),** called vibrations element, configured to generate a field of vibrations of the cooling liquid in the fluid conduit, called vibrations area.

2. The cooling block of claim 1, wherein a frequency of the vibrations element **(200)** is comprised between 30 Hz and 500 Hz, advantageously 150 Hz to 300Hz, and/or 20 kHz and 50 kHz, advantageously 25 kHz, and/or between 0.8 MHz and 1.2 MHz, advantageously 1 MHz, and/or between 1.3 MHz and 1.7 MHz, advantageously 1.5 MHz, and/or between 1.8 MHz and 2.2 MHz, advantageously 2 MHz.

3. The cooling block of claim 1 or 2, wherein the vibrations element **(200)** is arranged on the external surface of the body.

4. The cooling block of any of the preceding claims, wherein the vibrations element **(200)** is configured such that the field generated presents a principal direction forming an angle between 0° to 360° with a longitudinal axis of the cooling block **(160).**

5. The cooling block of any of the preceding claims, comprising at least a first vibrations element (**200-1**) and a second vibrations element (**200-2**).

6. The cooling block of the preceding claim, wherein the first and second vibrations elements (**200-1, 200-2**) are configured such that a frequency of the first vibrations element (**200-1**) is different from a frequency of the second vibrations element (**200-2**).

7. The cooling block of claim 5 or 6, wherein the first and second vibrations elements (**200-1, 200-2**) are configured such that that the field generated by the first vibrations element (**200-1**) presents a principal direction forming a non-zero angle with a principal direction of the field generated by the second vibrations element (**200-2**).

8. The cooling block of the preceding claim, wherein the principal direction of the field generated by the first vibrations element (**200-1**) is perpendicular to the principal direction of the field generated by the second vibrations element (**200-2**).

9. The cooling block of any of the preceding claims, wherein an acoustic power of the acoustic waves generator is comprised between 50 W and 200 W, advantageously 100 W.

10. A liquid cooling arrangement for of a datacenter server rack, comprising
liquid cooling loop configured to convey a cooling liquid;
a plurality of server clusters, each server cluster including a plurality of server assemblies that incorporate at least one respective liquid cooling unit as of any of the preceding claims, and configured to collect at least a portion of a thermal energy generated by a heat-generating component;
at least one heat exchanger fluidly connected to the liquid cooling units of the plurality of server clusters via the liquid cooling loop; and
a pump (130) fluidly coupled to the heat exchanger via the liquid cooling loop, the pump configured to convey the cooling liquid in the liquid cooling loop.

11. The liquid cooling arrangement of claim 10, wherein said at least one exchanger is disposed on a rear door of a rack hosting the server clusters.

12. The liquid cooling arrangement of claim 10 or 11, wherein said at least one exchanger is configured to cool the air flow with the cooling liquid circulating in the thermal exchanges zone.

## Amended claims

### Amended claims in accordance with Rule 137(2) EPC.

1. A cooling block **(160)** for cooling a heat-generating electronic component **(166),** comprising:
a body **(162)** having an external surface **(162),** called thermal transfer surface, configured to be placed in thermal contact with the heat-generating electronic component,
the body defining a fluid conduit (115) for circulating a cooling fluid therein, the fluid conduit having at least an inlet (110) for receiving the cooling fluid and at least an outlet (112) for discharging the cooling fluid,
the cooling block further comprising at least one acoustic wave generator **(200),** called vibrations element, configured to generate a field of vibrations of the cooling liquid in the fluid conduit, called vibrations area.
wherein a frequency of the vibrations element **(200)** is comprised between between 1.8 MHz and 2.2 MHz, advantageously 2 MHz.

2. The cooling block of claim 1, wherein the vibrations element **(200)** is arranged on the external surface of the body.

3. The cooling block of any of the preceding claims, wherein the vibrations element (200) is configured such that the field generated presents a principal direction forming an angle between 0° to 360° with a longitudinal axis of the cooling block **(160).**

4. The cooling block of any of the preceding claims, comprising at least a first vibrations element **(200-1)** and a second vibrations element **(200-2).**

5. The cooling block of the preceding claim, wherein the first and second vibrations elements **(200-1, 200-2)** are configured such that a frequency of the first vibrations element **(200-1)** is different from a frequency of the second vibrations element **(200-2).**

6. The cooling block of claim 4 or claim 5, wherein the first and second vibrations elements **(200-1, 200-2)** are configured such that that the field generated by the first vibrations element **(200-1)** presents a principal direction forming a non-zero angle with a principal direction of the field generated by the second vibrations element **(200-2).**

7. The cooling block of the preceding claim, wherein the principal direction of the field generated by the first vibrations element **(200-1)** is perpendicular to the principal direction of the field generated by the second vibrations element **(200-2).**

8. The cooling block of any of the preceding claims, wherein an acoustic power of the acoustic waves generator is comprised between 50 W and 200 W, advantageously 100 W.

9. A liquid cooling arrangement for of a datacenter server rack, comprising
liquid cooling loop configured to convey a cooling liquid;
a plurality of server clusters, each server cluster including a plurality of server assemblies that incorporate at least one respective liquid cooling unit as of any of the preceding claims, and configured to collect at least a portion of a thermal energy generated by a heat-generating component;
at least one heat exchanger fluidly connected to the liquid cooling units of the plurality of server clusters via the liquid cooling loop; and
a pump (130) fluidly coupled to the heat exchanger via the liquid cooling loop, the pump configured to convey the cooling liquid in the liquid cooling loop.

10. The liquid cooling arrangement of the preceding claim, wherein said at least one exchanger is disposed on a rear door of a rack hosting the server clusters.

11. The liquid cooling arrangement of claim 9 or 10, wherein said at least one exchanger is configured to cool the air flow with the cooling liquid circulating in the thermal exchanges zone.
